# EUROPEAN PATENT SPECIFICATION

(11) **EP 0 432 825 B1**
(45) Date of publication and mention of the grant of the patent: **09.08.1995**
(21) Application number: 90203137.6
(22) Date of filing: 27.11.1990
(51) Int. Cl.: H01L 23/495, H01L 23/498

(54) **Interconnection lead having individual spiral lead design**
Verbindungsleiter bestehend aus einem spiralförmigen Leiterentwurf
Conducteur d'interconnexion ayant une conception individuelle en spirale

(30) Priority: 11.12.1989 US 448453
(43) Date of publication of application: 19.06.1991
(73) Proprietor: DELCO ELECTRONICS CORPORATION, Kokomo Indiana 46902 (US)
(72) Inventor: Eytcheson, Charles T., Kokomo, Indiana 46902 (US)
(74) Representative: Denton, Michael John

(56) References cited:
- US-A- 3 519 890
- US-A- 4 003 073
- PATENT ABSTRACTS OF JAPAN vol. 014, no. 016 (E-872) 12 January 1989 & JP-A-01 258436

## Description

The present invention generally relates to electrical interconnections which are suitable for electrically connecting a plurality of bonding sites on an integrated circuit to a plurality of external connections as specified in the preamble of claim 1, for example as shown in US-A-3,519,890.

Many methods are known for forming the electrical interconnections between an integrated circuit and a supporting substrate.
Tape-automated-bonding (TAB) is one commonly-known method for forming such electrical interconnections. A TAB tape is provided which comprises a plurality of individual long, slender, inner leads attached to, and extending out from, generally wider, larger,outer leads. There may be many of these inner/outer lead configurations on a single TAB tape.

An individual inner lead on the TAB tape is generally bonded to the integrated circuit at a bonding pad so as to form an inner lead bond. There are typically many of these inner lead bonds on a single integrated circuit. The inner lead bonds are formed by first depositing a gold bump, or other suitable material, on either the end of the TAB tape inner lead or on the integrated circuit itself. The integrated circuit and TAB tape inner leads, which are generally copper, are then aligned and simultaneously thermocompression gang-bonded.

After bonding between the integrated circuit and inner leads is complete, the integrated circuit is excised from the TAB tape at a point beyond the outer lead, so that the outer lead remains attached to the bonded inner lead and integrated circuit. The integrated circuit assembly is subsequently mounted on a substrate, if this has not already been done, and the outer leads are appropriately bonded to the substrate.

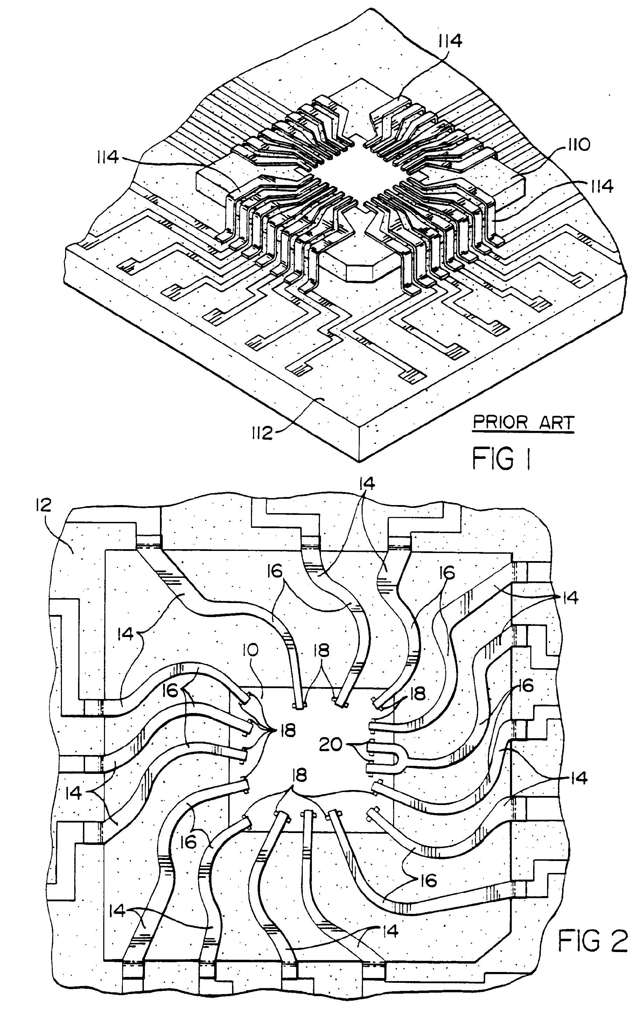

Strain relief must be provided in the interconnection lead structure between the integrated circuit and supporting substrate, so as to compensate for any thermal or physical stresses arising during use. Generally strain relief is provided by forming the individual interconnection lead structures in a serpentine manner, as shown in the accompanying Figure 1, thereby permitting expansion of the individual leads during use.

However, a shortcoming associated with the use of these individual serpentine leads is that the associated stresses become unbalanced during use due to the varying lead lengths and positioning of each lead from different directions. This unbalanced state results in higher failure rates for the individual bonds and correspondingly for the device. In addition, the current serpentine design results in increased lead stress during mounting of the integrated circuit to a substrate or other surface, since the varying lengths of each lead again result in an unbalanced stress load during mounting.

Therefore, it would be advantageous to provide an electrical interconnection lead structure which provides for balanced stress relief during use and mounting of the integrated circuit.

It is an object of the present invention to provide an electrical interconnection lead structure for electrically and physically connecting an integrated circuit to a plurality of external connections.

It is a further object of this invention that such an electrical interconnection lead structure should provide enhanced strain relief during use of the integrated circuit.

An electrically-conductive interconnection lead structure according to the present invention is characterised by the features specified in the characterising portion of Claim 1.

An interconnection lead structure is provided for electrically and physically connecting a plurality of bonding sites on an integrated circuit to a plurality of external electrical connections. The interconnection lead structure contains a plurality of individual electrical leads. Each of the individual electrical leads is formed so as to have an arcuate region at the region where each individual lead is bonded to the integrated circuit. In addition, the arcuate regions are all of similar length and are all disposed in the same direction in rotation around the integrated circuit.

This design provides enhanced strain relief during use, since the arcuate regions permit limited rotation of the integrated circuit during mounting or excessive applied lead stress. Because the leads are all disposed so as to rotate in the same direction around the integrated circuit, the applied stress is more balanced than with previous methods.

Other objects and advantages of this invention will be better appreciated from the following detailed description thereof.

The invention and how it may be performed are hereinafter particularly described with reference to the accompanying drawings, wherein like references refer to like parts and in which:
Figure 1 illustrates a conventional interconnection lead structure generally used throughout the art; and
Figure 2 illustrates an interconnection lead structure in accordance with a preferred embodiment of this invention.

An interconnection lead structure is provided for electrically and physically connecting a plurality of bonding sites on an integrated circuit to a plurality of external electrical connections. The interconnection lead structure contains a plurality of individual electrical leads. Each of the individual electrical leads is formed so as to have an arcuate region at the region where each individual lead is bonded to the integrated circuit. In addition, the arcuate regions are all of similar length and are all disposed in the same direction in rotation around the integrated circuit.

As shown in Figure 2, an integrated circuit 10 is electrically and physically connected to a surrounding substrate 12 of appropriate material by means of a plurality of electrically-conductive leads 14. Each electrically-conductive lead 14 is formed so as to have an arcuate region 16 adjacent a region 18 where the lead 14 is bonded to the integrated circuit 10. The arcuate regions 16 are generally of similar length and are disposed substantially in the same direction in rotation around the integrated circuit 10.

This electrical interconnection lead structure provides enhanced strain relief during use of the integrated circuit 10, since the arcuate regions 16 permit limited rotation of the integrated circuit 10 during mounting or excessive stress. With this design, the leads rotate in a similar direction during applied stress instead of in various directions as with conventional designs. This design results in a more balanced stress load around the integrated circuit, thereby improving the durability of the individual leads and correspondingly the integrated circuit.

In particular, if the integrated circuit remains free-floating after being bonded to the individual leads 14, such as with tape automated bonding methods, the integrated circuit is free to rotate during any applied stress, thereby advantageously reducing stress to the leads and to the integrated circuit. The ability to rotate equally balances the applied stress between all of the integrated circuit bonds. Alternatively, if the integrated circuit is mounted to a substrate or other surface, such as a heat sink, this design compensates for any differences in vertical tolerances. This is accomplished since the spiral leads twist during the vertical down-setting and the integrated circuit rotates with equal deflection to each of the individual leads. This rotational motion results in balanced stresses to each integrated circuit bond. Even after mounting, the twisted, spiral lead design still retains adequate length and curvature to provide good strain relief.

The plurality of individual leads 14 are bonded to the integrated circuit 12 at the arcuate regions 16. As illustrated the arcuate regions 16 may vary in degree of curvature. They may range from a slight amount of curvature to a larger degree of curvature approaching a semi-circular shape. The degree of curvature will vary depending on the position and location of the electrical connection in relation to its corresponding area to be bonded on the integrated circuit 10. Regardless of the degree of curvature, it is important that all arcuate regions 16 are disposed so as to extend in the same direction of rotation around the integrated circuit. This is necessary for providing enhanced strain relief. In addition, as clearly illustrated in Figure 2, a single electrical lead 14 having an arcuate region 16 may provide two or more regions 20 for bonding with the integrated circuit 10.

This electrical interconnection lead structure provides enhanced strain relief during use of the integrated circuit. Although this invention has been described in terms of a preferred embodiment, alternative embodiments are also possible and considered within the scope of this invention, such as the application of these techniques to an alternative bonding method such as flexible circuitry or to an integrated circuit being mounted to a printed circuit board.

## Claims

1. An electrically-conductive interconnection lead structure having the form of a tape useable in a tape-automated-bonding apparatus to electrically connect a plurality of bonding sites (18) on an integrated circuit (10) to a plurality of external electrical connections, said interconnection lead comprising a plurality of individual electrical leads (14), each of said individual electrical leads (14) having an arcuate region (16) thereof which, when said lead (14) is electrically connected to said integrated circuit (10), is positioned adjacent a respective bonding site (18) on said integrated circuit (10), characterized in that said arcuate regions (16) are of similar length to one another and each of them is disposed relative to the integrated circuit (10) so as to extend in the same spiral direction of rotation around the integrated circuit (10), thus providing a balanced stress load in said electrical leads (14) around said integrated circuit (10) which is connected only to said individual leads (14), so as to be free to rotate in response to any applied stress.

2. A device having an integrated circuit (10) electrically and physically connected to an appropriate substrate (12) by an electrically-conductive interconnection lead structure according to claim 1.

## Patentansprüche

1. Eine elektrisch leitfähige Verbindungsleiterstruktur mit der Form eines Bandes für den Gebrauch in einer automatischen Bandverbindungsvorrichtung, um eine Vielzahl von Verbindungsorten (18) auf einem integrierten Schaltkreis (10) mit einer Vielzahl von externen elektrischen Verbindungen elektrisch zu verbinden, wobei die Verbindungsleitung eine Vielzahl von einzelnen elektrischen Leitern (14) umfaßt, wobei jeder der einzelnen elektrischen Leiter (14) einen gebogenen Bereich (16) darin aufweist, der, wenn der Leiter (14) elektrisch mit dem integrierten Schaltkreis (10) verbunden ist, benachbart zu einem entsprechenden Verbindungsort (18) auf dem integrierten Schaltkreis (10) positioniert ist,
dadurch **gekennzeichnet**
daß die gebogenen Bereiche (16) jeweils eine ähnliche Länge zueinander haben und jeder von ihnen relativ zu dem integrierten Schaltkreis (10) derart angeordnet ist, daß er sich in der gleichen Spiraldrehrichtung um den integrierten Schaltkreis (10) herum erstreckt, und daher eine ausgeglichene Beanspruchungslast in den elektrischen Leitern (14) um den integrierten Schaltkreis (10) herum schafft, der nur mit den einzelnen Leitern (14) verbunden ist derart, daß er als Reaktion auf jegliche aufgebrachte Beanspruchung frei drehbar ist.

2. Ein Gerät mit einem integrierten Schaltkreis (10), der elektrisch und physikalisch mit einem geeigneten Substrat (12) durch eine elektrisch leitfähige Verbindungsleiterstruktur nach Anspruch 1 verbunden ist.

## Revendications

1. Structure de conducteur d'interconnexion électriquement conducteur ayant la forme d'une bande adaptée pour être utilisée dans un appareil de liaison automatique par bande pour relier électriquement une pluralité d'emplacements de liaison (18) sur un circuit intégré (10) à une pluralité de connexions électriques externes, ledit conducteur d'interconnexion comprenant une pluralité de conducteurs électriques individuels (14), chacun desdits conducteurs électriques individuels (14) comprenant une région recourbée (16) qui, lorsque ledit conducteur (14) est électriquement relié audit circuit intégré (10), est positionnée de manière adjacente à un emplacement de liaison (18) respectif sur ledit circuit intégré (10), caractérisée en ce que lesdites régions recourbées (16) sont de longueurs sensiblement égales et en ce que chacune desdites régions est disposée par rapport au circuit intégré (10) de telle sorte qu'elles s'étendent dans la même direction spiralée de rotation autour du circuit intégré (10), de manière à fournir un effort équilibré dans lesdits conducteurs électriques (14) au voisinage dudit circuit intégré (10) qui est uniquement relié auxdits conducteurs individuels (14), de manière à être libre de tourner en réponse à un effort appliqué quelconque.

2. Dispositif comprenant un circuit intégré (10) électriquement et mécaniquement relié à un substrat approprié (12) au moyen d'une structure de conducteur d'interconnexion électriquement conducteur selon la revendication 1.
